(19) Europäisches Patentamt
European Patent Office
Office européen des brevets

(11) **EP 2 503 556 B1**

(12) **EUROPEAN PATENT SPECIFICATION**

(45) Date of publication and mention
of the grant of the patent:
**12.10.2016 Bulletin 2016/41**

(51) Int Cl.:
**G11C 11/18** (2006.01)    **G01R 33/00** (2006.01)
**H01L 43/04** (2006.01)    **H03B 15/00** (2006.01)
**B82Y 25/00** (2011.01)    G06N 3/063 (2006.01)

(21) Application number: **12161274.1**

(22) Date of filing: **26.03.2012**

(54) **Memristive system**

Memristives System

Système memristif

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.03.2011 EP 11159905**

(43) Date of publication of application:
**26.09.2012 Bulletin 2012/39**

(73) Proprietor: **Technische Universität Dresden
01069 Dresden (DE)**

(72) Inventors:
• **Cai, Weiran
01069 Dresden (DE)**
• **Ellinger, Frank
01069 Dresden (DE)**

(74) Representative: **Lippert, Stachow & Partner
Patentanwälte
Krenkelstrasse 3
01309 Dresden (DE)**

(56) References cited:
**US-A1- 2005 169 034**

• **WEIRAN CAI ET AL: "A Feedback Spin-Valve
Memristive System", IEEE TRANSACTIONS ON
CIRCUITS AND SYSTEMS I: REGULAR PAPERS,
1 January 2012 (2012-01-01), XP55029854, ISSN:
1549-8328, DOI: 10.1109/TCSI.2012.2189043**
• **XIAOBIN WANG ET AL: "Spintronic Memristor
Through Spin-Torque-Induced Magnetization
Motion", IEEE ELECTRON DEVICE LETTERS,
IEEE SERVICE CENTER, NEW YORK, NY, US, vol.
30, no. 3, 1 March 2009 (2009-03-01), pages
294-297, XP011251008, ISSN: 0741-3106**
• **YURIY PERSHIN ET AL: "Frequency doubling and
memory effects in the spin Hall effect", PHYSICAL
REVIEW B, vol. 79, no. 15, 1 April 2009
(2009-04-01) , XP55029914, ISSN: 1098-0121, DOI:
10.1103/PhysRevB.79.153307**
• **DELGADO A: "The memristor as controller",
NANOTECHNOLOGY MATERIALS AND DEVICES
CONFERENCE (NMDC), 2010 IEEE, IEEE,
PISCATAWAY, NJ, USA, 12 October 2010
(2010-10-12), pages 376-379, XP031811281, ISBN:
978-1-4244-8896-4**
• **DI VENTRA M ET AL: "Circuit Elements With
Memory: Memristors, Memcapacitors, and
Meminductors", PROCEEDINGS OF THE IEEE,
IEEE. NEW YORK, US, vol. 97, no. 10, 1 October
2009 (2009-10-01), pages 1717-1724,
XP011276722, ISSN: 0018-9219, DOI:
10.1109/JPROC.2009.2021077**

**Description**

The present invention relates to a memristive system and a method to induce a memristive effect.

In 1971, the concept of the memristor was developed by Leon O. Chua at Berkeley (see L. O. Chua, IEEE Trans. Circuit Theory 18, 507 (1971)). But it was not until 2008 that S. Williams and his group at Hewlett-Packard Laboratories implemented their $TiO_{2-x}$ memristor as the first memristor (see D. B. Strukov, G. S. Snider, D. R. Stewart, and S. R. Williams, Nature (London) 453, 80 (2008)). It was also from then on that nonlinear electronics has been recognized as one of the comprising bases of the entire mansion of electronics. No later than this revival Di Ventra et al. had pushed the concept forward to a large family of passive memory systems, consisting of memristive, memcapacitive and meminductive systems (see M. Di Ventra, Y. V. Pershin, and L. O. Chua, Proc. IEEE 97, 1717 (2009)). Deeper insights have also permeated into the territory of biophysiology, building links between neuronal transmissions, learning rules and memristive behaviour, making it an indeed interdisciplinary research subject. Parallel to the conceptual development, researchers have been enthused in seeking memristive systems on new physical mechanisms, at both the material level and the device level. Among them is the spintronics of great interest, which has linked the memristive concept to amounts of established research results in this area. The spin Hall Effect in a semiconducting system with an inhomogeneous electron density has demonstrated a hysteretic pinch under periodically driving voltages (see Y. V. Pershin and M. Di Ventra, Phys. Rev. B 79, 153307 (2009)), and the spin diffusion and relaxation processes in the semiconductor/half-metal junction can also exhibit a memristive behavior (see Y. V. Pershin and M. Di Ventra, Phys. Rev. B 78, 113309 (2008)). On the other hand, in the metal material, memristive systems are realizable by employing spin-torque-induced magnetization switching or magnetic-domain-wall motion (see X. Y. Wang, H. Xi, Chen, H. Li, and D. Dimitrov, Elec. Dev. Lett. 30, 294 (2009) and A. M. Bratkovsky, Reports on Progress in Physics 71, 026502 (2008)).

The work has been focused on different spin polarization mechanisms to elaborate a complete memristive system. But also the configuration to get back the signal is a very important aspect of such a system.

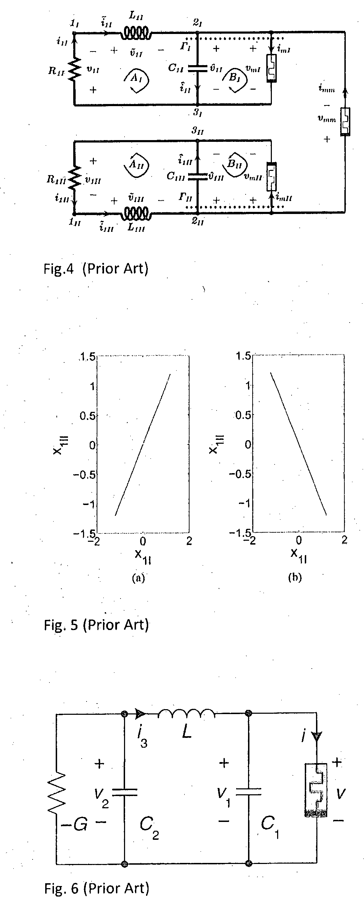

Commercial applications of memristors include oscillators and controllers. The memristor is a typical element which can be used to implement nonlinear circuits, including memristor-based oscillators, chaotic circuits. Furthermore, the memristor can be used to construct a control loop. Fernando Corinto, Alon Ascoli, and Marco Gilli, Nonlinear. Dynamics of Memristor Oscillators, IEEE TRANSACTIONS ON CIRCUITS AND SYSTEMS-I: REGULAR PAPERS, VOL. 58, NO. 6, JUNE 2011 relates to memristor based oscillators exhibiting synchronization. Fig. 4 shows the two-memristive oscillator network. Fig. 5 shows in-phase (a) and anti-phase (b) behaviors of the oscillator network shown in Fig. 4.

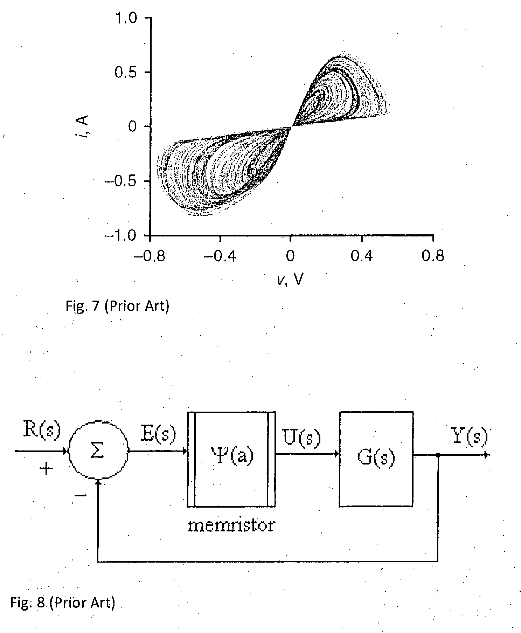

B.C. Bao, Z. Liu and J.P. Xu, Steady periodic memristor oscillator with transient chaotic behaviours, ELECTRONICS LETTERS, 2010 Vol. 46 No. 3 relates to a memristor based oscillator. Fig. 6 shows the canonical Chua's oscillator with memristor. Fig. 7 shows a chaotic attractor of the oscillator shown in Fig.6.

A. Delgado, The Memristor as Controller, 2010 IEEE

Nanotechnology Materials and Devices Conference Oct 12 - 15, 2010, Monterey, California, USA relates to a possible control loop comprising a memristor as a controller as shown in Fig. 8. An error signal E(s) is the difference between reference signal R(s) and measured system output Y(s). The error signal is fed to the controller which is a memristor in this case. The controller changes the inputs U(s) of a system under control of G(s). The system output Y(s) is fed back.

It is an object of the present invention to design a memristive system containing a simple structure to feedback the signal and to find a method of inducing a memristiven effect implying a simple feedback step.

This object is achieved through providing a memristive system according to claim 1, a method of inducing a memristive effect according to claim 6 and the usage of a memristive system according to claim 10. The claims 2 to 5 and 7 to 9 reflect preferred embodiments of the invention.

The memristive system according to the invention principally comprises means for generating a spin polarization process and means for generating a memory effect in the voltage-current phase plane, in a way that these means are arranged in a feedback loop architecture, such that the feedback loop is established by combining the spin polarization process with the action of a classical Hall effect, wherein a Hall current is fed back by transforming the Hall current to a magnetic flux.

From the methodical point of view, a memristive effect is induced by establishing a feedback loop process that combines a spin polarization process with the action of the classical Hall effect.

According to a further aspect of the present invention, the feedback loop architecture of the proposed memristive system comprises a giant magnetoresistive (GMR) material and a coil. The feedback loop controls the spin polarization in a giant magnetoresistive material via the classical Hall Effect, which gives rise to a memory behaviour.

In an advantageous embodiment of the invention, the giant magnetoresistive (GMR) material contains a stacked thin-film material formed as a spin-valve device. That is, it consists of two or more conducting materials. At least one of these materials, the "ferromagnetic material", may be strongly influenced if a magnetic field is applied to it in a way that it is strongly polarized by the magnetic field. This means results in a spin-alignment within this material. At least one other of the above mentioned conducting materials, the "non-ferromagnetic material", either does not show at all or shows only a polarization effect at a very low, insignificant level while applying the same magnetic field to it. The so formed spin-valve device alternates its electrical resistance depending on the level of spin-alignment within the ferromagnetic material. This allows the exploit the so-called Giant Magnetoresistive effect while placing a stack of layers of these materials in an alterable magnetic field.

So this advantageous embodiment represents a spin-valve memristive system established on a feedback loop.

In a further preferred embodiment the above mentioned stacked thin-film material is realized by a periodic succession of a ferromagnetic layer and a non-ferromagnetic layer. While applying a magnetic field, the ferromagnetic layer will be spin-polarized while roughly no effect will be seen within the non-ferromagnetic layer.

In a most advantageous embodiment of the memristive system according to the invention the thin film material is arranged in a current-perpendicular-to-plane (CPP) configuration. That is, an external voltage u resulting in an external current i is applied perpendicularly to the mentioned layers of the GMR material. In other words, the current direction is parallel to the stack direction.

This current-perpendicular-to-plane (CPP) configuration of the thin film stack is to adopt for yielding the highest giant magnetoresistance along the external current, which may possess a GMR coefficient = $(R_{\uparrow\downarrow} - R_{\uparrow\uparrow}) / R_{\uparrow\uparrow}$ exceeding 1 at the present time.

As already mentioned above in a more general way, considering a giant magnetoresistive (GMR) stacked thin-film material based on the spin-valve mechanism, the resistance reveals a strong dependence on the applied magnetic field (see M. N. Baibich, J. M. Broto, A. Fert, F. Nguyen Van Dau, F. Petroff, P. Eitenne, G. Creuzet, A. Friederich and J. Chazelas, Phys. Rev. Lett. 61, 2472 (1988)). This resistance may be empirically characterized by a hyperbolic function of the magnetic flux $\Phi_m$ as

$$R(\Phi_m) = R_{\uparrow\uparrow} + (R_{\uparrow\downarrow} - R_{\uparrow\uparrow}) \operatorname{sech}\left(\frac{\Phi_m}{\Phi_{m0}}\right) \quad (1)$$

In such structures, the parallel spin alignment corresponds to a low resistance $R_{\uparrow\uparrow}$ and the anti-parallel spin alignment corresponds to a high resistance $R_{\uparrow\downarrow}$. $\Phi_{m0}$ denotes a normalization quantity with the dimension of magnetic flux.

To give rise to a memristive effect, the classical Hall Effect is employed to feed back a magnetic field as a control of the spin polarization in the ferromagnetic layers of the GMR material. The classical Hall Effect is based on a balance between the Lorenz force and the established inner electric field. The Hall electromotive force $\varepsilon_H$ is related to a magnetic field on the conductor by

$$\varepsilon_H = \frac{1}{ned} B_i = \frac{1}{nedS} \Phi_m i \quad (2)$$

where n is the carrier density in the magnetoresistive conductor, e is the absolute value of the electron charge, d is the transverse scale of the conductor, S = a*b is the horizontal cross-section area of the conductor.

In a advantageous aspect of the method of inducing a memristive effect, an "external" current i is caused by an external voltage u on a magnetoresistive conductor, a magnetic field B is supplied internally by the Hall current iH, the Hall current is drawn out to a coil by the Hall electromotive force and the drawn out Hall current feeds back a controlling magnetic flux $\Phi_m$ on the magnetoresistive conductor.

This method will be explained now in some more details: The magnetic field B is supplied internally by the Hall current $i_H$. When the Hall current is drawn by the Hall electromotive force out to a coil, feeding back a controlling magnetic flux $\Phi_m$ the conductor itself, the balance is sustained in a dynamic way. The electromotive force equals the voltage drop on the coil

$$\varepsilon_H = \frac{d\Phi_m}{dt} + R_L i_H \quad (3)$$

where $R_L$ is the coil resistance. It is to note that attributed to the ferromagnetic core, the inductance L increases to a large extent with the enhanced permeability (by a factor of several hundred to thousand) and the dimension of the coil is allowed to be larger than that of the core due to the magnetic flux confinement. On the other hand, with the energy conservation, the entire system absorbs the power offered by an external voltage u(t), equaling to the dissipation in the resistance of the conductor and the power in the coil:

$$ui = i^2 R(\Phi_m) + \varepsilon_H\, i_H \quad (4)$$

In order to reveal the dominant factors contributing to the memristive dynamics, we base, the model of our invention on the following approximations:

Firstly, the magnetic flux changes with the Hall current $i_H$ linearly through an inductance L of the coil, i. e., $\Phi_m = L*i_H$. However, in terms of accuracy, it is worth pointing out that the ferromagnetic core saturation can cause a deviation from the linear relation at a high coil current.

Secondly, the coil resistance RL is constant. In a more accurate manner, this resistance also includes a transverse resistance of the ferromagnetic conductor. For simplicity, we suppose that the transverse resistance is relatively small (by properly choosing the size ratio of the GMR material) and its temporal change is negligible in series with the main coil resistance, and hence $R_L$ is regarded constant.

In the third place, other energy losses in the GMR material are not counted in for simplicity, which are mainly caused by the Eddy currents and the coercive losses (see, e.g., the GMR material in M. N. Baibich, J. M. Broto, A. Fert, F. Nguyen Van Dau, F. Petroff, P. Eitenne, G. Creuzet, A. Friederich and J. Chazelas, Phys. Rev. Lett. 61, 2472 (1988) with a low coercivity). These approximations aid to simplify the model, while at the same time maintain the factors determining the dynamics, esp. the orbital topologies of our main interest. When these non-ideal effects are involved, they will deform the orbital shapes and modify the parameters into a more realistic range, but retaining the topologies.

Based on the above factors and approximations, the complete dynamics of the proposed memristive system can eventually be defined by the following equation set:

$$u(t) = R(\Phi_m)i + \frac{D_0}{L}\Phi_m^2 \quad (5a)$$

$$\frac{d\Phi_m}{dt} = D_0\Phi_m i - \frac{R_L}{L}\Phi_m \quad (5b)$$

$$R(\Phi_m) = R_{\uparrow\uparrow} + (R_{\uparrow\downarrow} - R_{\uparrow\uparrow})\,\mathrm{sech}\left(\frac{\Phi_m}{\Phi_{m0}}\right) \quad (5c)$$

wherein $D_0$ denotes the coefficient 1/nedS. It is supposed here that the average exertion time, of spin torques under the magnetic field is sufficiently short compared to the time scale of the dynamics, and hence no time delay is involved in the above model. Special notice is to take on the extra term deviating to the resistive relation in Eq. (5a), which is responsible for giving rise to a new memory effect beyond standard memristive systems.

An additional advantage arises when being able to generate different dynamics of the memristive effect with the same. memristive system. That is why a very advantageous feature of the inventive method to induce a memristive effect is the aspect that at least two different types of hysteretic loops are realized by increasing or lowering the inductance of the coil L and/or the frequency f of the alternating external voltage signal. The term "loop" herein means an orbit or a closed curve.

To get from one type of hysteretic loop to the other, the system is first characterized by starting with a distinct set of parameters and then altering the inductance of the coil L and/or the frequency f of the alternating external voltage signal into a distinct direction, either to increased or to decreased values, while the alteration of the resulting hysteretic loop is observed.

In a special embodiment of the inventive method, a "single hystereric loop" is generated by applying a low inductance of the coil L and/or the a low frequency f of the alternating external voltage signal and a "pinched hysteretic loop" is generated by applying a high inductance of the coil L and/or a high frequency of the alternating external voltage signal. The single hysteric loop does not show the normally observed pinching effect with a self crossing point as of for pinched hysteric loops (the so-called "bi-loop"). Thus it is a new type of memristive dynamics.

So for the same device structure, a bi-phase dynamics is exhibited, adaptable by chosing two different parameter groups, leading to either a pinched hysteretic loop (as in a standard memristor) or a single hysteretic loop, permitting no self-crossing point at the origin.

So to sum up, the memristive system of this invention comprises a completely new device architecture as well as the method of inducing a memristing effect of this invention comprises a completely new technique. They are based on three formerly independent elements and effects: the general concept of memristor and memristive systems, the use of giant magnetoresistive (GMR) material and the application of the classical Hall Effect.

They come with a new feedback architecture, in an important aspect of the inventive system comprising a GMR material and a coil and present in another important aspect of the inventive method at least two types of distinct hysteretic loops. It allows operation in a low resistive range (i.e. in a typical conductor range).

The above described memristive system as well as the method of inducing a memristive effect according to the invention as well as to special aspects of the invention may be applied within neuromorphic systems and/or programmable analog signals and/or stateful logic circuits and/or low resistive range (e.g. conductor) applications, filling upto now existing gaps in these domains, opening the way to widely sought applications of these domains.

The memristive system according to the present invention exhibits a small memristance at the ohmic range. Therefore, it can be used as a compensating element for devices processing high memristance, for example, the one proposed by the HP laboratory. The potential applications of the memristive system are, but not exclusively, nonlinear circuits and control loops. Specifically, the memristive according to the present invention may be used in a control loop in which a low memristance is required.

The invention, as well as further features and advantages of the invention will be best understood by reference to the following detailed description, given purely by way of a non-restrictive indication, to be read in conjunction with the accompanying drawings:

Fig. 1 illustrates an application of the memristive system of this invention as well some special embodiments of the invention.

Fig. 2 shows a typical curve characterizing the relation between the giant magnetoresistance $R(\Phi_m)$ and the magnetic flux $\Phi_m$ of the memristive system of Fig. 1.

Fig. 3 represents different hysteretic loops obtainable by the method to induce a memrestive effect of the invention, using the memristic system of the invention, fig. 3a showing an example for a single hysteretic loop, fig. 3b another example for a pinched hysteric loop, both obtained for a sinusoidal input voltage signal; fig. 3c a single hysteric loop and a pinched hysteric loop a square wave input voltage signal.

Fig. 4 shows a two-memristive oscillator network according to prior art.

Fig. 5 shows in phase (a) and anti-phase (b) behaviors of the oscillator network shown in Fig.4.

Fig. 6 shows a Canonical Chua's oscillator according to prior art.

Fig. 7 shows a chaotic attractor of the oscillator shown in Fig.6.

Fig. 8 shows a possible loop comprising a memristor as a controller according to prior art.

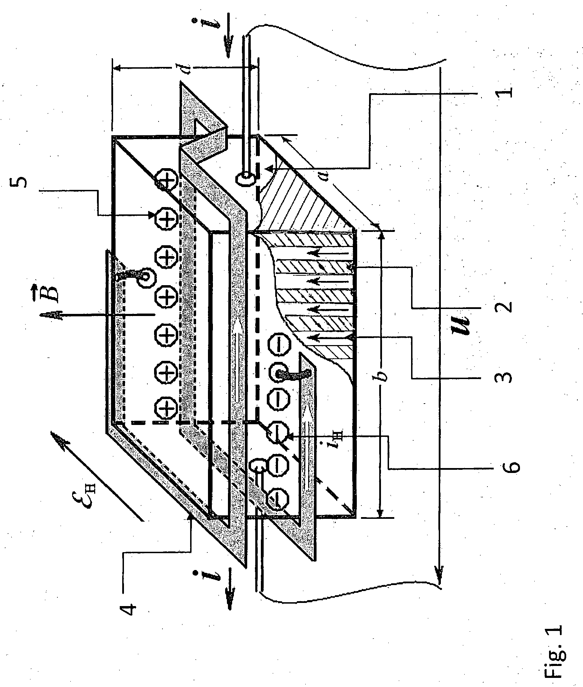

In detail, the fig. 1 proposes a memresistive system built up by a giant magnetoresistive material, containing a stacked thin film material 1 formed as spin-valve device in a current perpendicular-to-plane (CPP) configuration. The thin film stack is a realized by a periodic succession of a ferromagnetic layer 3 and a non-ferromagnetic layer 2. To give an example, this stack can be obtained by a periodic succession of a Fe-layer of a thickness between 1 and 2nm and a Cr-layer of a thickness of about 3nm. Without limiting to it, the total thickness of the stack might be in the order of micrometers.

In M. N. Baibich, J. M. Broto, A. Fert, F. Nguyen Van Dau, F. Petroff, P. Eitenne, G. Creuzet, A. Friederich and J. Chazelas, Phys. Rev. Lett. 61, 2472 (1988) or G. Binasch, P. Grünberg, F. Saurenbach and W. Zinn, Phys. Rev. B 39, 4828 (1989) examples for the realization of such stacked thin film giant magnetoresistive material 1 might be found.

A coil 4 is created winded around the giant magnetoresistive material 1 as shown in fig. 1, contacting the giant magnetoresistive material 1 in the planes perpendicular to the layers as shown in fig. 1. Thus the coil 4 may be alimented by the Hall current $i_H$, drawn out to the coil 4 by the Hall electromotive force $\varepsilon_H$ and feeding back a controlling magnetic flux $\Phi_m$ on the conductor, e.g. the stacked thin film giant magnetoresistive material 1 itself, once the system is in operation.

An alternating external voltage u is applied parallel to the stack direction of the stacked thin film giant magnetoresistive material 1, leading to a current i through this material.

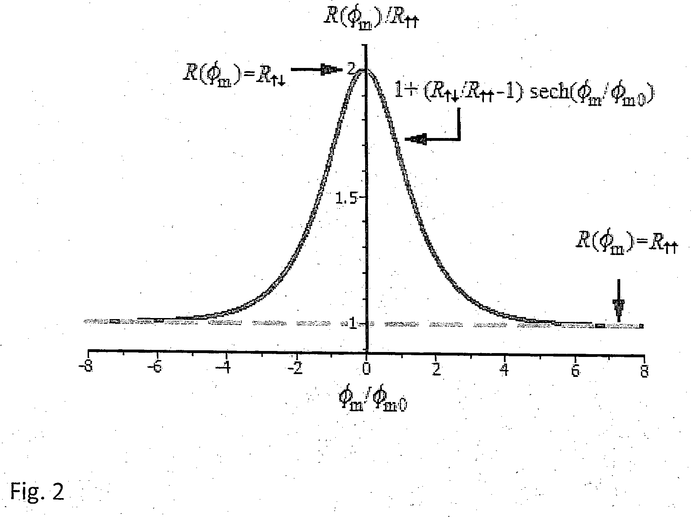

The spin in the ferromagnetic layers 3 are polarized adaptively to the temporally changing magnetic flux induced by the Hall current, while those in the non-ferromagnetic layers 2 are averaged to zero. The relation between the giant magnetoresistance $R(\Phi_m)$ and the magnetic flux $\Phi_m$ be described by an empirical formula with a hyperbolic function. Such a curve is depicted in fig. 2 with the ratio $R_{\uparrow\downarrow} / R_{\uparrow\uparrow} = 2$. It shows that the parallel spin alignment corresponds to low resistance $R_{\uparrow\uparrow}$ and the anti-parallel spin alignment corresponds to high resistance $R_{\uparrow\downarrow}$.

For the memristive system of fig. 1 the current-perpendicular-to-plane (CPP) configuration of the thin-film stack is to adopt, to yield to the highest giant magnetoresistance along the external current i, which possesses a GMR coefficient $\equiv (R_{\uparrow\downarrow} - R_{\uparrow\uparrow}) / R_{\uparrow\uparrow}$ that can exceed 1.

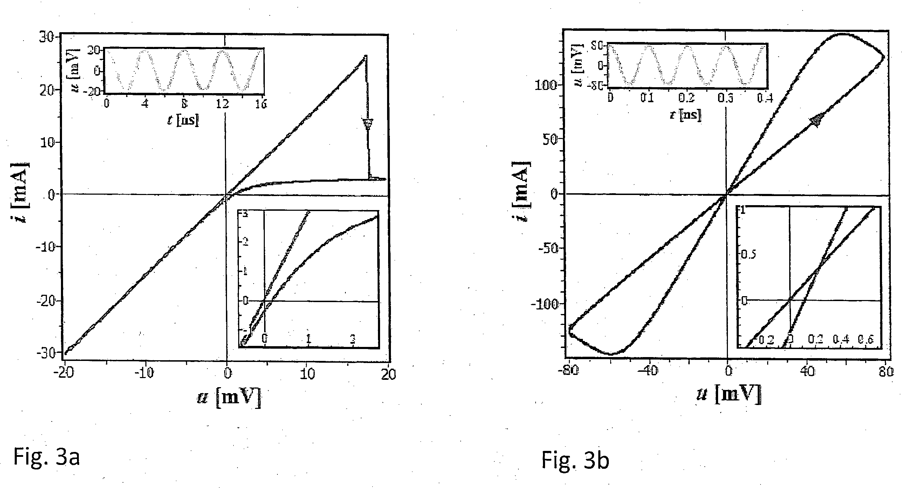

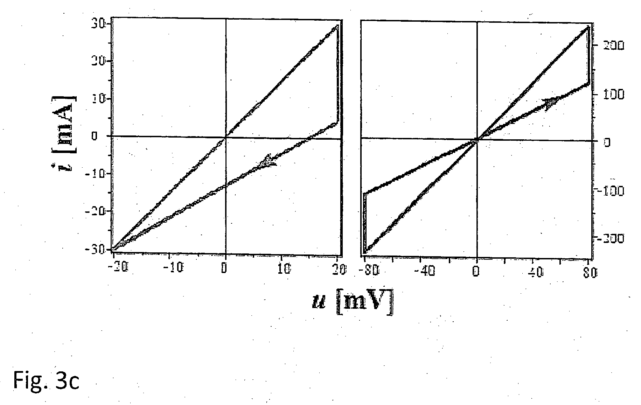

Coming to the bi-phase dynamics now, we can state that operating the proposed memristive system of the invention, both a single hysteretic loop and a pinched hysteretic loop may be obtained in the u -i phase plane when driven by a sinusoidal voltage signal ($u(t) = u_0 \cos(\omega t)$), as shown in Fig. 3. This is realized by choosing two different groups of parameters, as well as the input signal.

For both fig. 3a and fig. 3b, the following parameters were fixed: $e = 1.6 * 10^{-19}C$; $n = 10^{20}/cm^3$; $R_{\uparrow\uparrow} = 0.33\Omega$ ; $R_{\uparrow\downarrow} = 0.66 \Omega$ ; $R_L = 0.5\Omega$; $a = 1\mu m$; $b = 6\mu m$ and $d = 1\mu m$. The initial condition is set to be $\Phi_m(0) = 9pWb$.

In case of fig. 3a, further parameters were set as follows: $L = 4nH$ and $\Phi_{m0} = 5pWb$ with a sinusoidal amplitude $u_0 = 20mV$ at the frequency $f = \omega/2\pi = 0.25GHz$, leading to the shown single hysteretic loop as shown.

In case of fig. 3b, these respective parameters were set to: $L = 50nH$ and $\Phi_{m0} = 30pWb$ with $u_0 = 80mV$ at $f = 10GHz$, leading to the shown pinched hysteretic loop.

The zoomed-in display the deviation of the trajectory from the origin in fig. 3a as well as in fig. 3b.

So in contrast to the standard memristive systems, the trajectory crosses the origin only once in each period in case of the conditions chosen for fig. 3a, simply attributed to the additional non-zero term to the resistive relation in equation (5a). It is of special interest that the u - i planar dynamics exhibits this single hysteretic loop (i.e. non-pinched orbit), which is a new type of memristive dynamics, while in case of the conditions chosen for fig. 3b, it also exhibits a memristive hysteretic pinch, having its self-crossing point almost located at the origin as in a standard memristor.

Hard switching resposes under a square-wave input voltage signal demonstrates more clearly the two distinct topologies, as shown in fig. 3c. Globally, the two u - i orbits are topologically homeomorphic to the Lissajous figures for the ratio of 1 and 2, respectively.

Reference signs

| | |
|---|---|
| 1 | giant magnetoresistive (GMR) stacked thin-film material conductor |
| 2 | non-ferromagnetic layer |
| 3 | ferromagnetic layer |
| 4 | coil |
| 5 | induced positive changes |
| 6 | induced negative charges |

| | |
|---|---|
| I | external current |
| u | external voltage |
| B | magnetic field |
| $\varepsilon_H$ | Hall electromotive force |
| $i_H$ | Hall current |
| a | width of the conductor |
| b | length of the conductor |
| d | transverse scale of the conductor |
| $\Phi_m$ | magnetic flux |
| R | resistance |

**Claims**

1.  A memristive system comprising

        - means for generating a spin polarization process
        - means for generating a memory effect in the voltage-current phase plane

    **characterized in that**

- the mentioned means are arranged in a feedback loop architecture, such that the feedback loop is established by combining the spin polarization process with the action of a classical Hall effect, wherein a Hall current is fed back by transforming the Hall current to a magnetic flux.

**2.** The memristive system according to claim 1, **characterized in that** the feedback loop architecture comprises a giant magnetoresistive (GMR) material and a coil (4).

**3.** The memristive system according to claim 2, **characterized in that** the giant magnetoresistive (GMR) material contains a stacked thin-film material (1) formed as a spin-valve (device).

**4.** The memristive system according to claim **characterized in that** the stacked thin-film material is realized by a periodic succession of a ferromagnetic layer (3) and a non-ferromagnetic layer (2).

**5.** The memristive system according to claims 3 or 4 **characterized in that** the thin film material is arranged in a current-perpendicular-to-plane (CPP) configuration.

**6.** A method of inducing a memristive effect **characterized in that** a feedback loop is established by a combining spin polarization process with the action of the classical Hall effect.

**7.** The method according to claim 6, **characterized in that**

- a current (i) is caused by an external voltage (u) on a magnetoresistive conductor (1),
- a magnetic field B is supplied internally by the Hall current ($i_H$),
- the Hall current ($i_H$) is drawn out to a coil (4) by the Hall electromotive force ($\varepsilon_H$) and
- the drawn out Hall current ($i_H$) feeds back a controlling magnetic flux ($\Phi_m$) on the magnetoresistive conductor (1).

**8.** The method according to claim 7, **characterized in that** at least two different types of hysteretic loops are realized by increasing or lowering the inductance (L) of the coil (4) and the frequency (f) of the alternating external voltage signal (u).

**9.** The method according to claim 8, **characterized in that** a single hystereric loop is generated by applying a low inductance (L) of the coil (4) and/or the a low frequency (f) of the alternating external voltage signal (u) and a pinched hysteretic loop is generated by applying a high inductance (L) of the coil (4) and/or a high frequency (f) of the alternating external voltage signal (u).

**10.** Use of a memristive system according to one of the claims 1 to 5 and/or a method of inducing a memristive effect according to one of the claims 6 to 9, **characterized in that** it is applied within neuromorphic systems and/or programmable analog signals and/or stateful logic circuits and/or low resistive range applications.

**Patentansprüche**

**1.** Memristives System, das Folgendes umfasst:

- Mittel zum Erzeugen eines Spin-Polarisierungsvorgangs
- Mittel zum Erzeugen eines Speichereffekts in der Spannungs-Strom-Phasenebene

**dadurch gekennzeichnet, dass**

- die erwähnten Mittel in einer Rückkopplungsschleifenarchitektur angeordnet sind, derart, dass die Rückkopplungsschleife durch Kombinieren des Spin-Polarisierungsvorgangs mit dem Vorgang eines klassischen Hall-Effekts eingerichtet wird, wobei ein Hall-Strom durch Umwandeln des Hall-Stroms in einen magnetischen Fluss rückgekoppelt wird.

**2.** Memristives System nach Anspruch 1, **dadurch gekennzeichnet, dass** die Rückkopplungsschleifenarchitektur ein riesenmagnetoresistives Material (GMR-Material) und eine Spule (4) umfasst.

**3.** Memristives System nach Anspruch 2, **dadurch gekennzeichnet, dass** das riesenmagnetoresistive Material (GMR-Material) ein geschichtetes Dünnschichtmaterial (1) enthält, das als ein Spinventil (eine Spinventil-Vorrichtung) ausgebildet ist.

4. Memristives System nach Anspruch 3, **dadurch gekennzeichnet, dass** das geschichtete Dünnschichtmaterial durch eine periodische Folge einer ferromagnetischen Schicht (3) und einer nicht ferromagnetischen Schicht (2) realisiert wird.

5. Memristives System nach den Ansprüchen 3 oder 4, **dadurch gekennzeichnet, dass** das Dünnschichtmaterial in einer Strom-senkrecht-zur-Ebene-Konfiguration (CPP-Konfiguration) angeordnet ist.

6. Verfahren zum Induzieren eines memristiven Effekts, **dadurch gekennzeichnet, dass** eine Rückkopplungsschleife durch Kombinieren eines Spin-Polarisierungsvorgangs mit dem Vorgang des klassischen Hall-Effekts eingerichtet wird.

7. Verfahren nach Anspruch 6, **dadurch gekennzeichnet, dass**

- in einem magnetoresistiven Leiter (1) durch eine externe Spannung (u) ein Strom (i) verursacht wird,
- ein Magnetfeld B intern durch den Hall-Strom ($i_H$) bereitgestellt wird,
- der Hall-Strom ($i_H$) durch die elektromotorische Hall-Kraft ($\varepsilon_H$) in eine Spule (4) gezogen wird, und
- der gezogene Hall-Strom ($i_H$) einen steuernden Magnetfluss ($\Phi_m$) auf den magnetoresistiven Leiter (1) rückkoppelt.

8. Verfahren nach Anspruch 7, **dadurch gekennzeichnet, dass** durch Erhöhen oder Erniedrigen der Induktivität (L) der Spule (4) und der Frequenz (f) des externen Wechselspannungssignals (u) mindestens zwei verschiedene Typen von Hystereseschleifen realisiert werden.

9. Verfahren nach Anspruch 8, **dadurch gekennzeichnet, dass** durch Anlegen einer niedrigen Induktivität (L) der Spule (4) und/oder einer niedrigen Frequenz (f) des externen Wechselspannungssignals (u) eine einzelne Hystereseschleife erzeugt wird und dass durch Anlegen einer hohen Induktivität (L) der Spule (4) und/oder einer hohen Frequenz (f) des externen Wechselspannungssignals (u) eine eingeschnürte Hystereseschleife erzeugt wird.

10. Verwendung eines memristiven Systems nach einem der Ansprüche 1 bis 5 und/oder eines Verfahrens zum Induzieren eines memristiven Effekts nach einem der Ansprüche 6 bis 9, **dadurch gekennzeichnet, dass** sie in neuromorphischen Systemen und/oder in programmierbaren, analogen Signalen und/oder in zustandsorientierten logischen Schaltungen und/oder in Anwendungen im niederohmigen Bereich angewendet werden.

**Revendications**

1. Système memristif comprenant

- un moyen de génération d'un processus de polarisation du spin
- un moyen de génération d'un effet mémoire dans le plan de phase tension-courant

**caractérisé en ce que**

- les moyens mentionnés sont agencés dans une architecture de boucle de contre-réaction, de telle sorte que la boucle de contre-réaction soit établie en combinant le processus de polarisation du spin à l'action d'un effet de Hall classigue, dans lequel un courant de Hall est renvoyé par transformation du courant de Hall en un flux magnétique.

2. Système memristif selon la revendication 1, **caractérisé en ce que** l'architecture de boucle de contre-réaction comprend un matériau magnétorésistif géant (GMR) et une bobine (4).

3. Système memristif selon la revendication 2, **caractérisé en ce que** le matériau magnétorésistif géant (GMR) contient un matériau en couches minces superposées (1) formé en tant que vanne de spin (dispositif).

4. Système memristif selon la revendication 3, **caractérisé en ce que** le matériau en couches minces superposées est réalisé par une succession périodique d'une couche ferromagnétique (3) et d'une couche non ferromagnétique (2).

5. Système memristif selon la revendication 3 ou 4, **caractérisé en ce que** le matériau en couches minces est agencé dans une configuration de courant perpendiculaire au plan (CPP).

6. Procédé d'induction d'un effet memristif **caractérisé en ce qu'**une boucle de contre-réaction est établie en combinant un processus de polarisation du spin à l'action de l'effet de Hall classique.

7. Procédé selon la revendication 6, **caractérisé en ce que**

   - un courant (i) est causé par une tension externe (u) sur un conducteur magnétorésistif (1),
   - un champ magnétique B est fourni intérieurement par le courant de Hall ($i_H$),
   - le courant de Hall ($i_H$) est attiré vers une bobine (4) par la force électromotrice de Hall ($\varepsilon_H$) et
   - le courant de Hall ($i_H$) attiré renvoie un flux magnétique de commande ($\Phi_m$) sur le conducteur magnétorésistif (1).

8. Procédé selon la revendication 7, **caractérisé en ce qu'**au moins deux types différents de boucles d'hystérésis sont réalisés en augmentant ou réduisant l'inductance (L) de la bobine (4) et la fréquence (f) du signal de tension externe alternatif (u).

9. Procédé selon la revendication 8, **caractérisé en ce qu'**une seule boucle d'hystérésis est générée en appliquant une inductance faible (L) de la bobine (4) et/ou une fréquence basse (f) du signal de tension externe alternatif (u) et une boucle d'hystérésis pincée est générée en appliquant une inductance élevée (L) de la bobine (4) et/ou une haute fréquence (f) du signal de tension externe alternatif (u).

10. Utilisation d'un système memristif selon l'une des revendications 1 à 5 et/ou procédé d'induction d'un effet memristif selon l'une des revendications 6 à 9, **caractérisée en ce qu'**elle est appliquée dans des systèmes neuromorphiques et/ou des signaux analogiques programmables et/ou des circuits logiques d'état et/ou des applications de faible plage résistive.

Fig. 1

Fig. 2

Fig. 3b

Fig. 3a

Fig. 3c

Fig.4 (Prior Art)

(a)                              (b)

Fig. 5 (Prior Art)

Fig. 6 (Prior Art)

Fig. 7 (Prior Art)

Fig. 8 (Prior Art)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **L. O. CHUA.** *IEEE Trans. Circuit Theory,* 1971, vol. 18, 507
- **D. B. STRUKOV ; G. S. SNIDER ; D. R. STEWART ; S. R. WILLIAMS.** *Nature,* 2008, vol. 453, 80
- **M. DI VENTRA ; Y. V. PERSHIN ; L. O. CHUA.** *Proc. IEEE,* 2009, vol. 97, 1717
- **Y. V. PERSHIN ; M. DI VENTRA.** *Phys. Rev. B,* 2009, vol. 79, 153307
- **Y. V. PERSHIN ; M. DI VENTRA.** *Phys. Rev. B,* 2008, vol. 78, 113309
- **X. Y. WANG ; H. XI ; CHEN ; H. LI ; D. DIMITROV.** *Elec. Dev. Lett.,* 2009, vol. 30, 294
- **A. M. BRATKOVSKY.** *Reports on Progress in Physics,* 2008, vol. 71, 026502
- **FERNANDO CORINTO ; ALON ASCOLI ; MARCO GILLI ; NONLINEAR.** Dynamics of Memristor Oscillators. *IEEE TRANSACTIONS ON CIRCUITS AND SYSTEMS-I: REGULAR PAPERS,* 06 June 2011, vol. 58
- **B.C. BAO ; Z. LIU ; J.P. XU.** Steady periodic memristor oscillator with transient chaotic behaviours. *ELECTRONICS LETTERS,* 2010, vol. 46 (3
- **A. DELGADO.** The Memristor as Controller. IEEE, 2010
- *Nanotechnology Materials and Devices Conference,* 12 October 2010
- **M. N. BAIBICH ; J. M. BROTO ; A. FERT ; F. NGUYEN VAN DAU ; F. PETROFF ; P. EITENNE ; G. CREUZET ; A. FRIEDERICH ; J. CHAZELAS.** *Phys. Rev. Lett.,* 1988, vol. 61, 2472
- **G. BINASCH ; P. GRÜNBERG ; F. SAURENBACH ; W. ZINN.** *Phys. Rev. B,* 1989, vol. 39, 4828